# EUROPEAN PATENT APPLICATION

(11) **EP 2 808 894 A1**
(43) Date of publication of application: **03.12.2014**
(21) Application number: 14158801.2
(22) Date of filing: 11.03.2014
(51) Int. Cl.: H01L 27/32, H01L 51/52

(54) **Organic light emitting display module and display device including the same**

(30) Priority: 31.05.2013 KR 20130062965
(71) Applicant: Samsung Display Co., Ltd., Yongin-City, Gyeonggi-Do, 446-711 (KR)
(72) Inventor: Yi, Sang Min, Gyeonggi-do (KR); Yang, Seung Yo, Gyeonggi-do (KR); Lee, Jung-Ha, Gyeonggi-do (KR)
(74) Representative: Walaski, Jan Filip

(57) **Abstract**

An organic light emitting display module includes a display panel, a bracket, and a sheet structure body. The display panel includes an organic light emitting diode. The bracket is coupled to the display panel to support the display panel. The sheet structure body is interposed between the display panel and the bracket. The sheet structure body includes a first sheet for heat dissipation and a second sheet for impact absorption.

## Description

The invention relates to an organic light emitting display module and a display device including the organic light emitting display module.

Organic light emitting display (OLED) modules are used for digital display devices such as television screens, computer monitors, or mobile phones. The OLED modules include a display panel on which an organic light emitting diode is formed. The organic light emitting diode includes an emissive electroluminescent layer that emits light in response to an electric current. The organic light emitting diode further includes two electrodes to supply the electric current, and the emissive electroluminescent layer is interposed between the two electrodes. The OLED modules holds the display panel using a mechanical structure.

According to an exemplary embodiment of the present invention, an organic light emitting display module includes a display panel, a bracket, and a sheet structure body. The display panel includes an organic light emitting diode. The bracket is coupled to the display panel to support the display panel. The sheet structure body is interposed between the display panel and the bracket. The sheet structure body includes a first sheet for heat dissipation and a second sheet for impact absorption.

According to an exemplary embodiment of the present invention, an organic light emitting display module includes a display panel including an organic light emitting diode, a bracket coupled to the display panel to support the display panel, and a sheet structure body interposed between the display panel and the bracket. The sheet structure body includes a first sheet for heat dissipation and a second sheet for impact absorption, a front cabinet disposed on the display panel, surrounding outskirts of the display panel and a rear cabinet disposed on the bracket, covering the bracket. The front cabinet and the rear cabinet are coupled to each other thereby securing the the organic light emitting display module interposed the front cabinet and the rear cabinet.

According to an exemplary embodiment of the present invention, an organic light emitting display module includes a display panel, a sheet structure body, and a bracket. The display panel includes a display region and a non-display region. A plurality of organic light emitting diodes are disposed on the display region. The bracket includes a first plate, a second plate, and a barrier rib. The barrier rib has a honeycomb structure interposed between the first plate and the second plate. The sheet structure body is interposed between the display panel and the bracket. The sheet structure body includes a first sheet for heat dissipation and a second sheet for impact absorption.

These and other features of the invention will become more apparent by describing in detail exemplary embodiments thereof with reference to the accompanying drawings in which:
FIG. 1 is a perspective view of a display device having an organic light emitting display module according to an exemplary embodiment of the present invention;
FIG. 2 is an enlarged perspective view of the organic light emitting display module shown in FIG. 1 according to an exemplary embodiment of the present invention;
FIG. 3 is a sub-pixel circuit of a display panel shown in FIG. 1 according to an exemplary embodiment of the present invention;
FIG. 4 is a cross-sectional view of the display panel shown in FIG. 1 according to an exemplary embodiment of the present invention;
FIG. 5 is a perspective view of an organic light emitting display module according to an exemplary embodiment of the present invention;
FIG. 6 is an exploded perspective view of an organic light emitting display module according to an exemplary embodiment of the present invention;
FIG. 7 is a cross-sectional view of an organic light emitting display module according to an exemplary embodiment of the present invention;
FIG. 8 is an enlarged top view of a bracket of the organic light emitting display module of FIG. 7 according to an exemplary embodiment of the present invention; and
FIG. 9 is an enlarged view of portion IX of FIG. 7 according to an exemplary embodiment of the present invention.

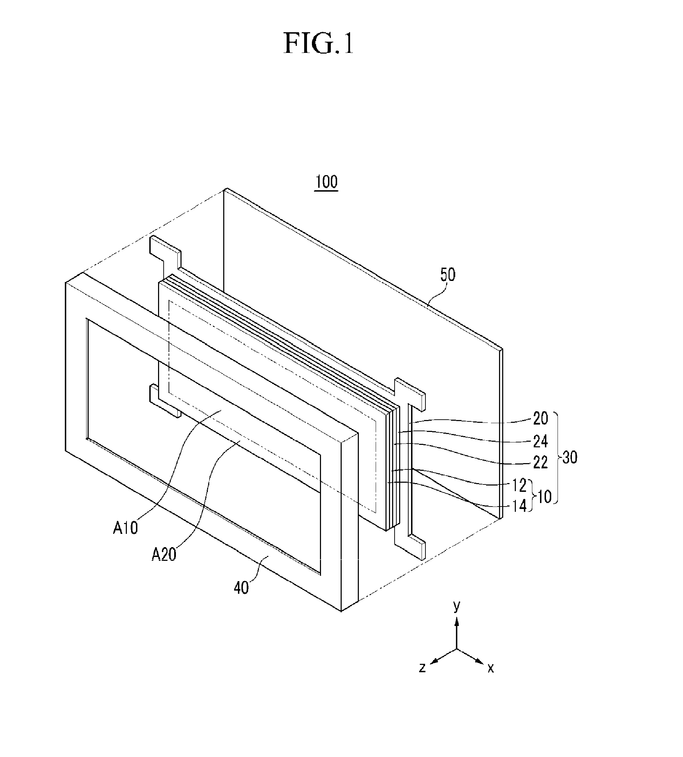

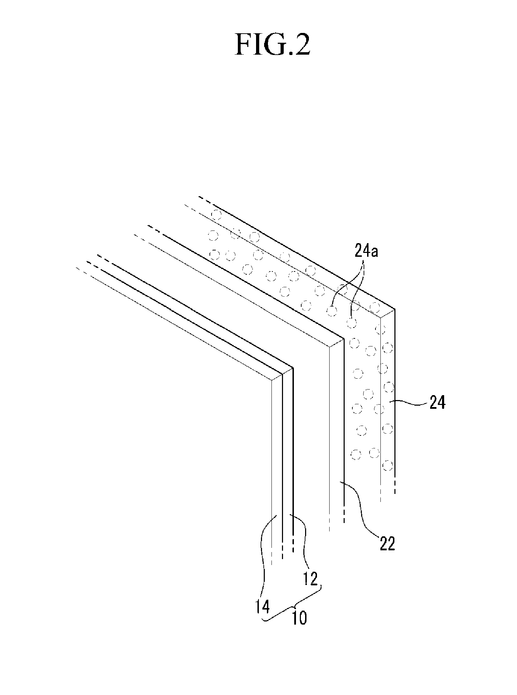

Referring to FIGS. 1 and 2, a display device 100 includes a display panel 10, a bracket 20, a front cabinet 40 and a rear cabinet 50. The display panel 10 and bracket 20 form part of an organic light emitting display module 30. The bracket 20 is coupled to a rear of the display panel 10 to support the display panel 10. A printed circuit board (not shown) is provided on a rear surface of the bracket 20. The front cabinet 40 and the rear cabinet 50 serve to hold the display panel 10 coupled to the bracket 20.

The display panel 10 includes a first substrate 12 and a second substrate 14 facing each other. The first substrate 12 and the second substrate 14 are attached to each other by a sealant. A display region A10 displaying an image is positioned in an overlapping region of the first substrate 12 and the second substrate 14, and a non-display region A20 is positioned on the outside of the display region A10.

The front cabinet 40 surrounds the non-display region A20.

Sub-pixels are disposed in a matrix form in the display region A10 of the first substrate 12. For example, pad electrodes (not shown) for transmitting an electric signal are provided between the sub-pixels and the printed circuit board in the non-display region A20 of the first substrate 12.

The pad electrodes are coupled to the printed circuit board using a flexible circuit board (not shown). For example, the flexible circuit board may be provided in the non-display region A20 in a chip on film (COF) manner to be electrically coupled to the printed circuit board disposed at the rear of the bracket 20.

A scan driver (not shown) and a data driver (not shown) for driving the sub-pixels may be mounted on the printed circuit board. A control board (not shown) may be separately provided at the rear of the bracket 20. Electronic diodes (not shown) may be mounted on the control board. A driving signal may be processed according to an external signal and may be transmitted to the printed circuit board.

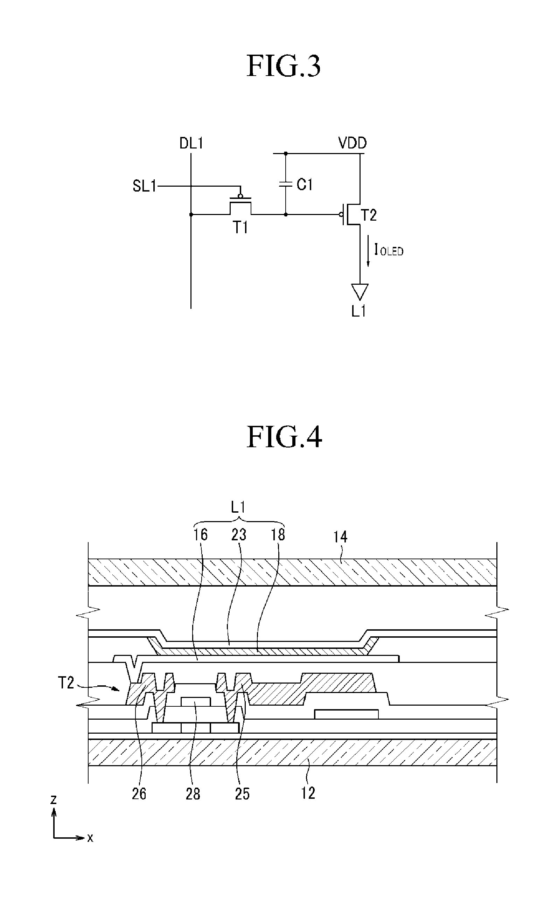

Referring to FIGS. 3 and 4, the sub-pixel of the display panel 10 includes an organic light emitting diode L1 and a driving circuit unit. The organic light emitting diode L1 includes an anode 16, an organic light emitting layer 18, and a cathode 23.

The driving circuit unit includes at least two thin film transistors and at least one storage capacitor C1. The thin film transistor includes a switching transistor T1 and a driving transistor T2.

The switching transistor T1 is coupled to a scan line SL1 and a data line DL1, and transmits a data voltage inputted from the data line DL1 to the driving transistor T2 according to a switching voltage inputted to the scan line SL1.

The storage capacitor C1 is coupled to the switching transistor T1 and a power line VDD, and stores a voltage corresponding to a difference between the voltage transmitted from the switching transistor T1 and a voltage supplied from the power line VDD.

The driving transistor T2 is coupled to the power line VDD and the storage capacitor C1 to supply an output current IOLED that is proportional to the square of a difference between the voltage stored in the storage capacitor C1 and a threshold voltage of the driving transistor T2. The organic light emitting diode L1 emits light due to the output current IOLED.

The driving transistor T2 includes a source electrode 25, a drain electrode 26, and a gate electrode 28. The anode 16 of the organic light emitting diode L1 may be coupled to the drain electrode 26 of the driving transistor T1. The sub-pixel circuit is not limited to the aforementioned example, and may be configured in various ways.

Referring back to FIGS. 1 and 2, the organic light emitting display module 30 includes a sheet structure body having a double layered structure of a first sheet 22 and a second sheet 24. The sheet structure body is interposed between the display panel 10 and the bracket 20.

The first sheet 22 serves to disspate heat that is generated from the display panel 10.

The second sheet 24 serves to absorb an impact that is applied to the display device 100. For example, the first sheet 22 may include a material having high thermal conductivity, such as graphite, copper, or aluminum. The second sheet 24 may include a material that absorbs an impact to protect the display device 100 from the impact applied from the outside of the display device 100. For example, the second sheet 24 may include polyethylene (PE) or low-density polyethylene (LDPE). The second sheet 24 may be porous. For example, the second sheet 24 may have a plurality of air cavities 24a formed therein. The second sheet 24 has thermal conductivity that is relatively lower than that of the first sheet 22.

The display panel 10 has a quadrangle (rectangular) shape having a pair of long sides and a pair of short sides. The first sheet 22 and the second sheet 24 have a quadrangle shape corresponding to the display panel 10.

For example, the first sheet 22 is substantially congruent with the display panel 10. The first sheet 22 is in close contact with an entire surface of the display panel 10. For example, the second sheet 24 is substantially congruent with the bracket 20. The second sheet 24 is in close contact with the bracket 20.

The first sheet 22 and the second sheet 24 are interposed between the display panel 10 and the bracket 20. The first sheet 22 and the second sheet 24 are in close contact with each other. In this case, the first sheet 22 and the second sheet 24 each may have a thickness of about 1 mm or less.

When the organic light emitting display module 30 including the sheet structure body is assembled using the front cabinet 40 and the rear cabinet 50 to form the display device 100, the organic light emitting display module 30 and the display device 100 including the same may have increased impact resistance and heat resistance characteristics.

For example, if an external impact is applied to the display device 100, the second sheet 24 having the impact absorption characteristic absorbs the impact thereby protecting the organic light emitting display module 30 from the impact. Accordingly, the organic light emitting display module 30 and the display device 100 have the increased impact resistance characteristic.

The second sheet 24 is also formed of a material having low thermal conductivity thereby insulating heat that is generated from the printed circuit board. The printed circuit board is provided on the rear surface of the bracket 50, generating heat when the display device 100 is driven. Accordingly, the second sheet 24 serves to insulate the display panel 10 from heat generated from the outside. Accordingly, the second sheet 24 serves to prevent the display panel 10 from malfunctioning due to heat generated from the outside of the display panel 10.

For example, the first sheet 22 has high thermal conductivity thereby rapidly dissipating heat generated from the display panel 10. The first sheet 22 dissipates the heat to the outside of the display device 100.

The first sheet 22 and the second sheet 24 serve to uniformly distribute heat that is generated from the display panel 10. The uniform temperature distribution increases the image quality of the display panel 10. The second sheet 24 serves to insulate the display region A10 from heat that is generated from the outside of the display panel 10.

The first sheet 22 and the second sheet 24 may be substantially congruent with each other.

However, a configuration of the sheet structure body of the present invention is not limited thereto. Hereinafter, other configurations of the sheet structure body of the present invention will be described.

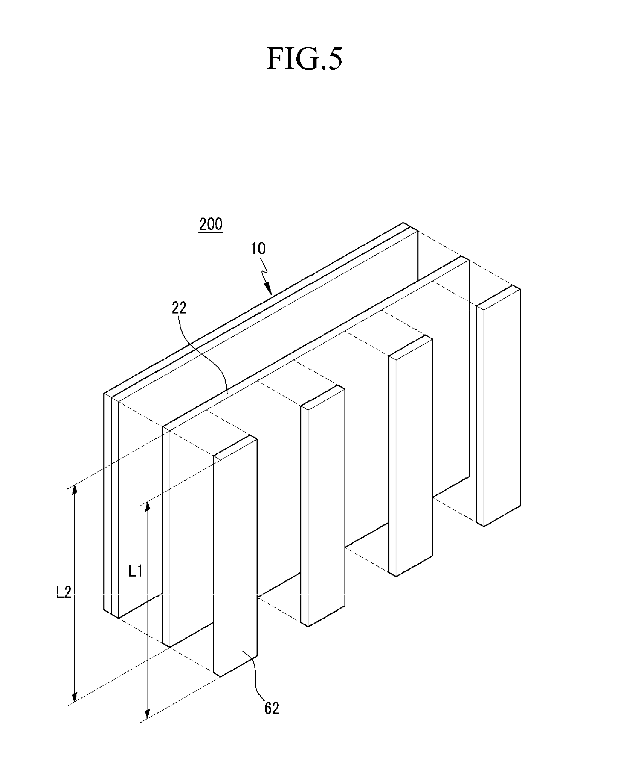

FIG. 5 is a perspective view illustrating an organic light emitting display module 200 according to an exemplary embodiment.

The organic light emitting display module 200 is substantially similar to that of FIG. 1, except for a second sheet 62. The second sheet 62 comprises a stripe pattern. In other words, strips (or stripes) of the second sheet material are spaced across the first sheet. As a result, the second sheet 62 has smaller area than that of the first sheet 22.

Each strip faces the first sheet 22. Each strip extends along the short sides of the display panel 10 and the first sheet 22 and is, for example, arranged at a regular interval along the long sides of the display panel 10 and the first sheet 22. In this case, a length L1 of each strip of the second sheet 62 is substantially the same as a length L2 of the short side of the first sheet 22. The relationship between the length L1 and the length L2 is not limited thereto, and may be appropriately adjusted to implement the inventive concept of the present invention.

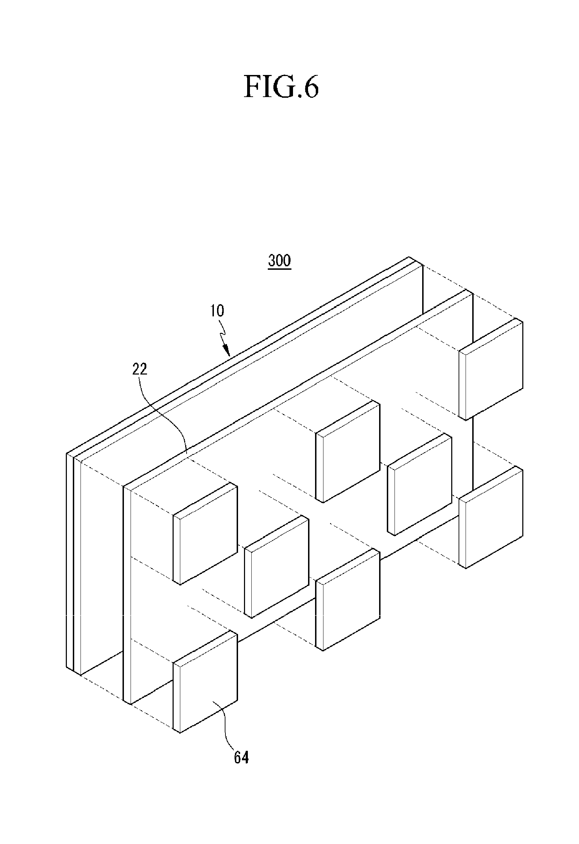

FIG. 6 is a perspective view illustrating an organic light emitting display module 300 according to an exemplary embodiment. The organic light emitting display module 300 is substantially similar to that of FIG. 1, except for a second sheet 64.

Referring to FIG. 6, the organic light emitting display module 300 includes the display panel 10, the first sheet 22, and the second sheet 64. The second sheet 64 includes a plurality of material portions that are arranged in a checkerboard pattern. The second sheet 64 is disposed on the first sheet 22. Each portion of the second sheet 64 is substantially square. The plurality of the portions are spaced apart from each other and is arranged in a checkerboard pattern. The pattern is not limited to the square shape, and may have different shapes.

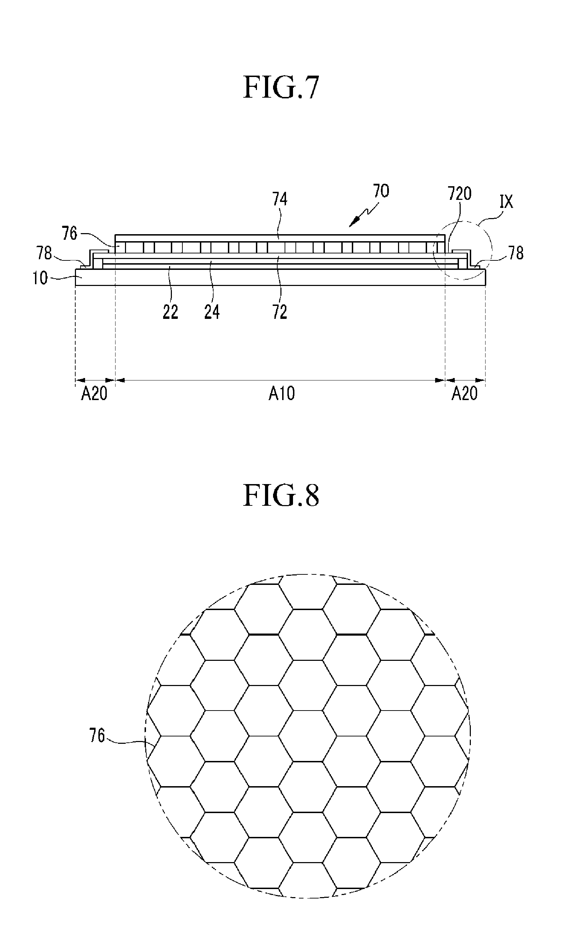

Hereinafter, an organic light emitting display module according to an exemplary embodiment will be described with reference to FIGS. 7 to 9.

Referring to FIG. 7, an organic light emitting display module 400 includes a display panel 10, a bracket 70, and a sheet structure body interposed therebetween.

The sheet structure body includes a first sheet 22 and a second sheet 24. The sheet structure body is substantially similar to that of FIGS. 1 and 2 or FIGS. 5 and 6.

The bracket 70 includes a first plate 72, a second plate 74, and a barrier rib structure 76.

The first plate 72 is approximately rectangular. The first plate 72 faces the sheet structure body. The first plate 72 is coupled to the display panel 10, supporting the display panel 10.

The second plate 74 is disposed on the first plate 72 so that the second plate 74 faces the first plate 72. The second plate 74 is approximately rectangular.

The barrier rib structure 76 is interposed between the first plate 72 and the second plate 74. The barrier rib structure 76 has a lower end coupled to an upper surface of the first plate 72 and an upper end coupled to a lower surface of the second plate 74. As shown in FIG. 8, the barrier rib structure 76 provides a space between the first plate 72 and the second plate 74 to form a honeycomb structure.

The honeycomb structure of the barrier rib structure 76 provides strength to the barrier rib structure 76 using less material. The honeycomb structure provides high strength-to-weight ratio to the barrier rib structure 76. The barrier rib structure 76 having the honeycomb structure further serves to dissipate heat generated to the outside in a first direction and a second direction. The first direction is substantially vertical to the first plate 72. The second direction crosses the first direction. Accordingly, the barrier rib 76 serves to rapidly dissipate the heat generated from the display panel 10 to the outside of the organic light emitting display module 400.

The first plate 72, the second plate 74, and the barrier rib structure 76 may include substantially the same material. For example, the first plate 72, the second plate 74, and the barrier rib structure 76 may include a metallic material such as aluminum. The first plate 72, the second plate 74, and the barrier rib structure 76 may be coupled to each other without forming a discontinuous surface at a junction disposed therebetween. Accordingly, the heat generated from the display panel 10 is continuously dissipated using the barrier rib structure 76.

The second plate 74 is smaller than the first plate 72 to the extent that an edge 720 of the first plate 72 is not covered by the second plate 74, thereby being exposed to the outside. The exposed edge 720 receives an outskirt plate 78, also referred to as a fixing plate, for fixing the exposed edge of the first plate 72 to a rear surface of the display panel, so holding the bracket to the display panel and in turn holding the sheets 22, 24 in place. The outskirt plate 78 is coupled to both the exposed edge 720 and a non-display region A20 of the display panel 10. The second plate 74 has substantially the same area as the display region A10 of the display panel 10.

The second plate 74 having the area that is narrower than that of the first plate 72 may be formed, using a pressing process, by removing the edge of a preliminary second plate having substantially the same area as the first plate 72. Since the bracket 70 having the honeycomb structure has a very low volume ratio, the edge of the second plate 74 is pressed.

The outskirt plate 78 may include at least two members that are disposed at opposite sides of the bracket 70 that correspond to the long sides or the short sides of the display panel 10 of FIG. 1. For example, the outskirt 78 may include four members. Two members are disposed at opposite sides of the bracket that corresponds to the long sides of the display panel 10 of FIG. 1. Remaining two members are disposed at opposite sides of the bracket that corresponds to the short sides of the display panel 10 of FIG. 1.

The outskirt plate 78 may be coupled to the bracket 70 using a double-sided tape or an adhesive. Alternatively, the outskirt plate 78 may be assembled with the pressed edge of the bracket 70 if the pressing process is performed to form the pressed edge. In this case, the outskirt plate 78 is held at a fixed position using a jig for the pressing process. In this case, a position of the outskirt plate 78 is determined before performing the pressing process. Accordingly, a process of pressing and cutting the edge of the second plate 74 has an enough allowance.

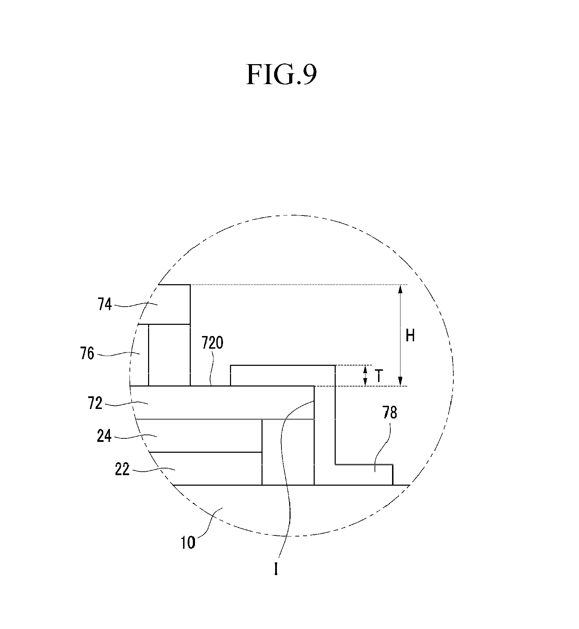

Referring to FIG. 9, the outskirt plate 78 is disposed on the exposed edge 720 of the first plate 72. As described above, the edge 720 of the first plate 72 corresponds to the non-display region A20 of the display panel 10. The outskirt plate 78 is positioned in the non-display region A20 of the display panel 10. Accordingly, the outskirt plate 78 does not decrease an image quality of the display panel 10. For example, a boundary I between the outskirt plate 78 and the first plate 72 is positioned in the non-display region A20 of the display panel 10. Therefore, a reduction in display quality of the display panel 10 due to the boundary I between the outskirt plate 78 and the first plate 72 is prevented.

The outskirt plate 78 may include substantially the same material as the first and the second plates 72 and 74, and the barrier rib structure 76. For example, the outskirt plate 78 may include a metallic material such as aluminum. The outskirt plate 78 may include substantially the same material as the bracket 70. Accordingly, the outskirt plate 78 does not reduce the display quality of the display panel 10.

The outskirt plate 78 has a thickness T that is substantially the same as or smaller than a distance H that is measured from an upper surface of the first plate 72 to an upper surface of the second plate 74. Herein, the upper surface of the first plate 72 faces a lower surface of the second plate 74. Accordingly, the thickness T of the outskirt plate 78 is equal to or less than the distance H. Accordingly, an upper surface of the outskirt plate 78 is disposed under the upper surface of the second plate 74 or is level with the upper surface of the second plate 74. The outskirt plate 78 does not increase the thickness of the bracket 70. The thickness of the bracket 70 is determined by the distance H. As described above, providing the outskirt plate 78 to the organic light emitting display module 400 does not increase the thickness of the bracket 70.

Accordingly, display panel 10 is supported using the bracket 70 having the honeycomb structure and a relatively small thickness.

According to an exemplary exemplary embodiment, in an organic light emitting display module and a display device, a sheet structure body provided between a display panel and a bracket insulates the display panel from heat generated from a printed circuit borad from while the display panel is driven. The printed circuit board may be provided at the rear of the bracket 20. A scan driver and a scan driver may be mounted on the printed circuit board. A control board may be provided at the rear of the bracket 20. Electric diodes (not shown) may be mounted on the control board.

The sheet structure body further protects absorbs an impact applied from the outside thereby protecting the display panel from the impact.

The sheet structure body further disspates heat generated from the display panel to the outside of the display device.

Further, the sheet structure body is separated and re-assembled when the sheet structure body has defects in the manufacturing process. Accordingly, a discarding ratio of products due to manufacturing defects is reduced.

Moreover, the sheet structure body has a relatively small thickness thereby securing the slimness of the organic light emitting display module and the display device including the same.

While the present invention has been shown and described with reference to exemplary embodiments thereof, it will be apparent to those of ordinary skill in the art that various changes in form and detail may be made therein without departing from the scope of the invention as defined by the following claims.

## Claims

1. An organic light emitting display module comprising:
a display panel including a plurality of organic light emitting diodes;
a bracket coupled to the display panel to support the display panel; and
a sheet structure body between the display panel and the bracket,
wherein the sheet structure body includes:
a first sheet for heat dissipation; and
a second sheet for impact absorption.

2. The organic light emitting display module of claim 1, wherein the first sheet is in close contact with the display panel, and the second sheet is in close contact with the bracket.

3. The organic light emitting display module of claim 1 or 2, wherein the first sheet is substantially congruent with the display panel, and the second sheet is substantially congruent with the bracket.

4. The organic light emitting display module of claim 1, 2 or 3, wherein the second sheet includes a plurality of stripes spaced apart from each other at a regular interval.

5. The organic light emitting display module of any one of claims 1 to 3, wherein the second sheet includes a plurality of portions that are spaced apart from each other and that are arranged in a checkerboard pattern on the first sheet.

6. The organic light emitting display module of any one of the preceding claims, wherein the second sheet is porous.

7. The organic light emitting display module of any one of the preceding claims, wherein the bracket includes:
a first plate having a first area disposed on the sheet structure body,
a second plate having a second area disposed on the first plate, wherein the second area is smaller than the first area, and
a barrier rib structure interposed between the first plate and the second plate.

8. The organic light emitting display module of claim 7, wherein the barrier rib structure comprises a honeycomb structure.

9. The organic light emitting display module of claim 7 or 8, wherein the first plate provides an edge that is not covered with the second plate, the edge being disposed in a non-display region of the display panel.

10. The organic light emitting display module of claim 9, wherein edges of the second plate are aligned with edges of the display region of the display panel, wherein the second plate has substantially the same area as the display region.

11. The organic light emitting display module of any one of claims 7 to 10, comprising a plurality of fixing plates for fixing the bracket to the display panel.

12. The organic light emitting display module of claim 11, wherein each of the fixing plates has a first surface coupled to an exposed edge of the bracket and a second surface coupled to a rear of the display panel.

13. The organic light emitting display module of any one of the preceding claims, wherein the first sheet includes graphite, copper, or aluminum.

14. The organic light emitting display module of any one of the preceding claims, wherein the second sheet includes polyethylene or low-density polyethylene.

15. A display device comprising:
an organic light emitting display module according to any one of the preceding claims;
a front cabinet disposed on the display panel, surrounding the display panel; and
a rear cabinet disposed on the bracket, covering the bracket,
wherein the front cabinet and the rear cabinet are coupled to each other thereby securing the organic light emitting display module between the front cabinet and the rear cabinet.
